# EUROPEAN PATENT SPECIFICATION

(11) **EP 3 267 492 B1**
(45) Date of publication and mention of the grant of the patent: **06.03.2019**
(21) Application number: 17179508.1
(22) Date of filing: 04.07.2017
(51) Int. Cl.: H01L 31/0224

(54) **SOLAR CELL**
SOLARZELLE
CELLULE SOLAIRE

(30) Priority: 05.07.2016 TW 105121204
(43) Date of publication of application: 10.01.2018
(73) Proprietor: Neo Solar Power Corp., Hsinchu City 300 (TW)
(72) Inventor: PEI, Shan-Chuang, 300 Hsinchu City (TW); YEH, Ching-Chun, 300 Hsinchu City (TW); HSU, Wei-Chih, 300 Hsinchu City (TW)
(74) Representative: Viering, Jentschura & Partner mbB Patent- und Rechtsanwälte

(56) References cited:
- EP-A2- 2 711 988
- CN-B- 102 623 522
- TW-A- 201 227 999
- US-A1- 2012 100 666
- US-A1- 2013 186 457
- US-A1- 2013 340 822

## Description

### BACKGROUND

### Technical Field

The instant disclosure relates to a solar cell.

### Related Art

Currently, traditional solar cell tech is the most matured and widely-applied green energy technologies. To improve the efficiency of power generation of the solar cell as well as reducing the cost for power generation, different solar cell structures are developed. Commonly, solar cells can be divided into three categories including silicon-based solar cells, compound semiconductor solar cells, and organic solar cells. Specifically, silicon-based solar cell tech is the most matured and developed; plus, the conversion efficiency of the silicon-based solar cell is the best among the three solar cell technologies.

Published silicon-bases solar cells with high conversion efficiency include hetero-junction with intrinsic thin layer (HIT) solar cells, interdigitated back contact (IBC) solar cells, bifacial solar cells, and passivated emitter rear cells (PERC).

Typically, the surface of the aforementioned solar cells has several bus-bar electrodes (e.g., two bus-bar electrodes) with wider line widths and several finger electrodes with thinner line widths. The finger electrodes are respectively at two sides of each of the bus-bar electrodes and extending along a direction perpendicular to the length direction of the corresponding bus-bar electrode. The bus-bar electrodes and the finger electrodes are formed on the surface of the semiconductor substrate by screen-printing.

An implementation of the conventional is forming the bus-bar electrodes and the finger electrodes on the surface of the semiconductor substrate directly; in this case, there is no significant difference between the doping concentration of the connection portion of the semiconductor substrate and the electrodes with the doping concentration of the rest of the semiconductor substrate. Another implementation of the conventional is applying a heavily doping to portions of the surface of the semiconductor substrate on which the finger electrodes are going to be formed prior to forming the bus-bar electrodes and the finger electrodes, and the area of the heavily doped portions is greater than the area of the surface of the semiconductor substrate covered by the finger electrodes; for example, the width of the finger electrode is approximately from 30 to 50 micrometers, while the width of the heavily doped portion is approximately from 50 to 400 micrometers. Accordingly, the contact resistance between the finger electrodes and the semiconductor substrate can be reduced. In the disclosure of China Patent NO. CN102623522B and Taiwan Patent NO. TW 201227999A, the heavily doped region 222a is only disposed under the electrode 242. In the disclosure of US 2013/186457 A1, the heavily doped region 121HF/121HB is only disposed under the electrode 140. In the disclosure of US 2013/340822 A1, the heavily doped region 121H is only disposed under the electrode 140.

The purpose of the conventional implementations is increasing the carrier collection rate by the net structured finger electrodes and further reducing the contact resistance between the electrodes and the semiconductor substrate by forming the heavily doped regions beneath the finger electrodes, thereby increasing the efficiency of the solar cell. However, the higher the proportion of the area of the electrodes with respect to the area of the surface of the solar cell is, the less the amount of the incident light is. As a result, the density of the finger electrodes is limited.

### SUMMARY

The object of the invention is achieved by the subject matter of claim 1. Advantageous embodiments are disclosed by the dependent claims. The conventional solar cells improve the carrier collection rate by densely distributed finger electrodes. However, the conventional has never thought about applying heavily doping on a specific portion of the surface of the solar cell to increase the conductivity of the specific portion so as to improve the carrier collection rate of the specific portion.

Accordingly, a solar cell is provided and comprises a semiconductor substrate, a bus-bar electrode, a plurality of finger electrodes, and a heavily doped layer. The semiconductor substrate has a first surface and a second surface opposite to the first surface. The bus-bar electrode is on the first surface and extending along a first direction. The finger electrodes are on the first surface and extending along a second direction. One of two ends of each of the finger electrodes is connected to the bus-bar electrode. An angle created by the first direction and the second direction is less than 180 degrees. The heavily doped layer is formed on the first surface and comprises a first portion and a plurality of second portions. The first portion is extending along the first direction. Each of the second portions is extending from an edge of the first portion along the second direction, and the each of second portions is beneath the corresponding finger electrode, wherein the first portion of the heavily doped layer is between a free end of each of the finger electrodes and an edge of the semiconductor substrate.

In one embodiment, a length of each of the second portions of the heavily doped layer along the second direction is greater than a length of each of the finger electrodes along the second direction.

In one embodiment, a length of each of the second portions of the heavily doped layer along the second direction is less than a length of each of the finger electrodes along the second direction.

In one embodiment, the other end of each of the finger electrodes is a free end.

In one embodiment, a connection between the first portion and each of the second portions are partially overlapped to form an overlapped region. A doping concentration of the overlapped region of the heavily doped layer is greater than doping concentrations of the rest of the heavily doped layer.

In one embodiment, the solar cell further comprises a plurality of connection electrodes, two ends of each of the connection electrodes are respectively connected to two of the finger electrodes adjacent to the connection electrode.

In one embodiment, the connection electrodes are extending along the first direction.

In one embodiment, the heavily doped layer further comprises a plurality of third portions, each of the third portions is extending along the first direction and beneath the corresponding - connection electrode.

In one embodiment, two ends of each of the third portions are respectively connected to two of the second portions adjacent to the third portion.

In one embodiment, the doping concentration of the heavily doped layer is from 1 x 10¹⁹ to 8 x 10¹⁹ atom/cm³.

In one embodiment, the doping concentration of the heavily doped layer is from 5.43 x 10¹⁸ to 2.84 x 10¹⁹ atom/cm³.

### BRIEF DESCRIPTION OF THE DRAWINGS

The disclosure will become more fully understood from the detailed description given herein below for illustration only, and thus not limitative of the disclosure, wherein:
Fig. 1 illustrates a schematic view of an exemplary embodiment of a solar cell of the instant disclosure showing the electrodes layout on the surface thereof;
Fig. 2 illustrates a partial enlarged view (1) of the portion P1 shown in Fig. 1;
Fig. 3 illustrates a partial enlarged view (2) of the portion P1 shown in Fig. 1;
Fig. 4 illustrates a partial enlarged view (3) of the portion P1 shown in Fig. 1;
Fig. 5 illustrates a partial enlarged view (4) of the portion P1 shown in Fig. 1;
Fig. 6 illustrates a partial enlarged view (5) of the portion P1 shown in Fig. 1;
Fig. 7 illustrates a partial enlarged view (6) of the portion P1 shown in Fig. 1;
Fig. 8 illustrates a partial enlarged view (7) of the portion P1 shown in Fig. 1;
Fig. 9 illustrates a schematic view of another exemplary embodiment of a solar cell of the instant disclosure showing the electrodes layout on the surface thereof; and
Fig. 10 illustrates a partial enlarged view of the portion P2 shown in Fig. 9.

### DETAILED DESCRIPTION

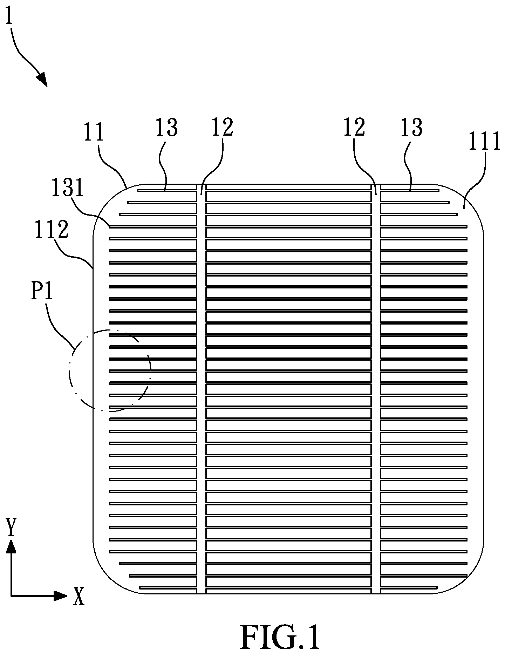

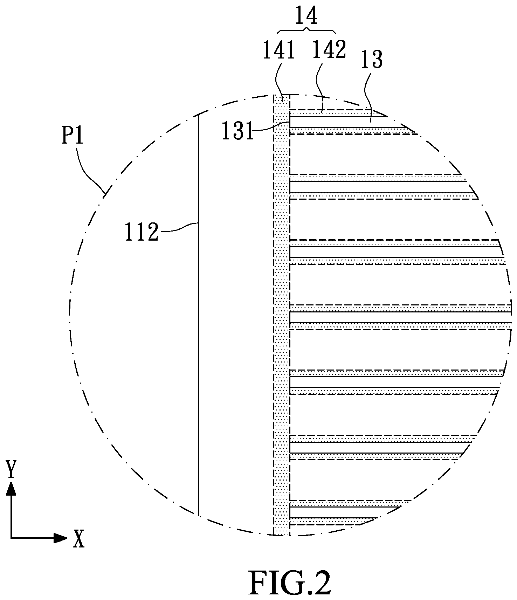

Figs. 1 and 2 respectively illustrate a schematic view of an exemplary embodiment of a solar cell of the instant disclosure showing the electrode layout on the surface thereof and a partial enlarged view (1) of the portion P1 shown in Fig. 1. As shown, the solar cell 1 comprises a semiconductor substrate 11, a bus-bar electrode 12, a plurality of finger electrodes 13, and a heavily doped layer 14. The semiconductor substrate 11 has a surface 111. The bus-bar electrode 12 is on the surface 111 of the semiconductor substrate 11 and extending along a first direction (e.g., the Y axis direction). The finger electrodes 13 are also on the surface of the semiconductor substrate 11 and extending along the second direction (e.g., the X axis direction). One of two ends of each of the finger electrodes 13 is connected to the bus-bar electrode 12. In this embodiment, as long as the angle created by the first direction and the second direction is less than 180 degrees, the first direction and the second direction are not limited to be the Y axis direction and the X axis direction. In addition, the surface 111 of the semiconductor substrate 11 may be the illuminated surface or the unilluminated surface, depending on the types of the solar cell 1. For example, if the solar cell 1 is a p-type solar cell, the illuminated surface would have lightly n-doped regions plus some selectively heavily n-doped regions in contact with the metal screen printing electrodes. In other words, the surface 111 of the semiconductor substrate 11 the bus-bar electrode 12 and the finger electrodes 13 are on or may be on the illuminated surface. Conversely, if the solar cell is an n-type solar cell, the unilluminated surface has lightly n-doped regions for providing rear electric field plus some selectively heavily n-doped regions in contact with the metal screen printing electrodes. In other words, the surface 111 of the semiconductor substrate 11, the bus-bar electrode 12 and the finger electrodes 13 are on may be the unilluminated surface. For a bifacial solar cell, both surfaces of the semiconductor substrate could be illuminated surface, therefore the heavily doped regions may be disposed on both surfaces of the semiconductor substrate. In summary, the selectively heavily doped regions may be disposed on either or both of the illuminated surface and the unilluminated surface to improve the carrier collection rate of a local location where they are disposed on.

The heavily doped layer 14 is formed on the surface 111 of the solar cell 11 and includes a first portion 141 and a plurality of second portions 142. The dopant of the heavily doped layer 14 may be P-type or N-type, depending on the types of the solar cell 1. The first portion 141 of the heavily doped layer 14 is approximately on the outer periphery of the surface 111 of the solar cell 1. Specifically, the first portion 141 of the heavily doped layer 14 is between a free end 131 of each of the finger electrodes 13 and an edge 112 of the semiconductor substrate 11. The first portion 141 of the heavily doped layer 14 is extending along the first direction (e.g., the Y axis direction). Each of the second portions 142 is extending from an edge of the first portion 141 along the second direction (e.g., the X axis direction), and each of the second portions 142 is beneath the corresponding finger electrode 13. In one embodiment shown in Fig. 2, a length of each of the second portions 142 along the second direction is equal to a length of each of the finger electrodes 13 along the second direction. In a projecting direction perpendicular to the surface 111 of the solar cell 1, neither the second portions 142 are overlapped with the first portion 141, nor the finger electrodes 13 are overlapped with the first portion 141.

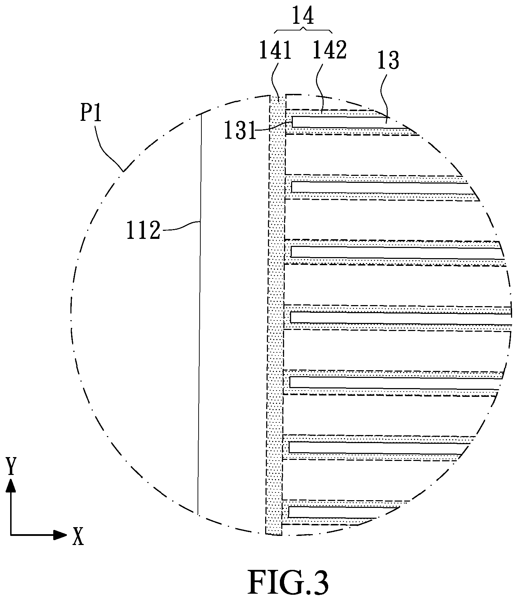

Fig. 3 illustrates a partial enlarged view (2) of the portion P1 shown in Fig. 1. As shown, in this embodiment, the length of each of the second portions 142 along the second direction is greater than the length of each of the finger electrodes 13 along the second direction. In the projecting direction perpendicular to the surface 111 of the solar cell 1, neither the second portions 142 are overlapped with the first portion 141, nor the finger electrodes 13 are overlapped with the first portion 141.

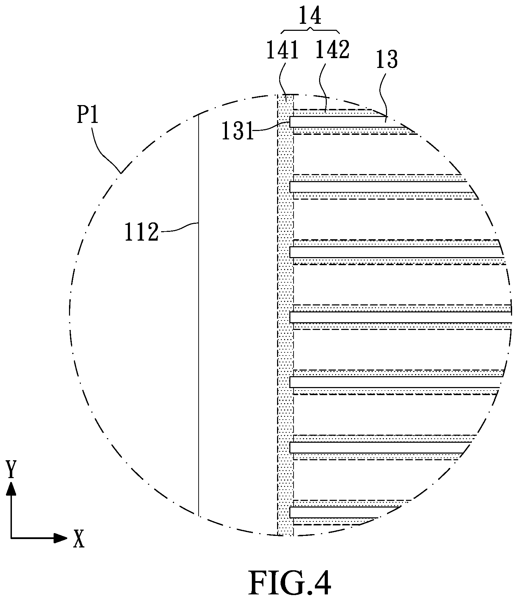

Fig. 4 illustrates a partial enlarged view (3) of the portion P1 shown in Fig. 1. As shown, in this embodiment, the length of each of the second portions 142 along the second direction is less than the length of each of the finger electrodes 13 along the second direction. In the projecting direction perpendicular to the surface 111 of the solar cell 1, the second portions 142 are not overlapped with the first portion 141, but the free ends 131 of the finger electrodes 13 are partially overlapped with the first portion 141.

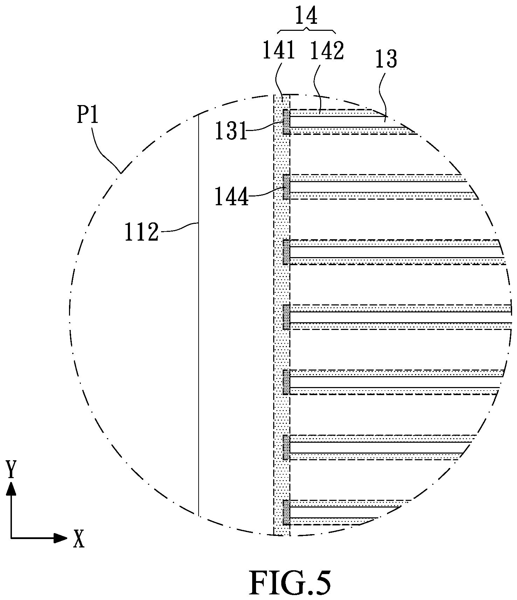

Fig 5 illustrates a partial enlarged view (4) of the portion P1 shown in Fig. 1. As shown, in this embodiment, the length of each of the second portions 142 along the second direction is greater than the length of each of the finger electrodes 13 along the second direction. In the projecting direction perpendicular to the surface 111 of the solar cell 1, the second portions 142 are partially overlapped with the first portion 141 to form overlapped regions 144, but the finger electrodes 13 are not overlapped with the first portion 141. A doping concentration of each of the overlapped regions 144 is greater than doping concentrations of the rest of the heavily doped layer 14.

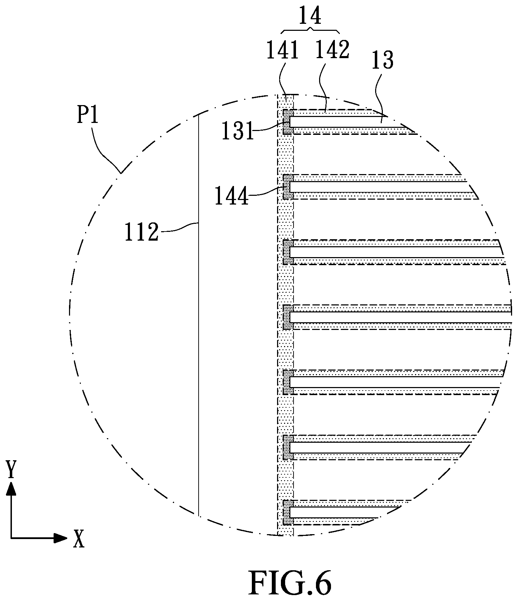

Fig. 6 illustrates a partial enlarged view (5) of the portion P1 shown in Fig. 1. As shown, in this embodiment, the length of each of the second portions 142 along the second direction is greater than the length of each of the finger electrodes 13 along the second direction. In the projecting direction perpendicular to the surface 111 of the solar cell 1, the second portions 142 are partially overlapped with the first portion 141 to form the overlapped regions 144, and the free ends 131 of the finger electrodes 13 are also partially overlapped with the first portion 141. The doping concentration of each of the overlapped regions 144 is greater than doping concentrations of the rest of the heavily doped layer 14.

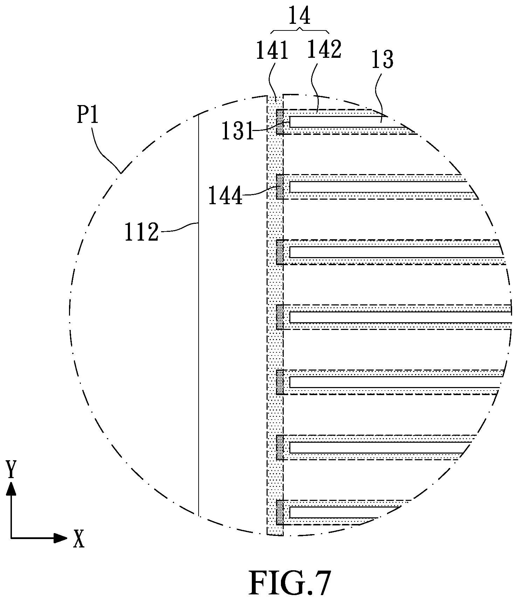

Fig. 7 illustrates a partial enlarged view (6) of the portion P1 shown in Fig. 1. As shown, in this embodiment, the length of each of the second portions 142 along the second direction is greater than the length of each of the finger electrodes 13 along the second direction. In the projecting direction perpendicular to the surface 111 of the solar cell 1, the second portions 142 are partially overlapped with the first portion 141 to form the overlapped regions 144, but the finger electrodes 13 are not overlapped with the first portion 141. A doping concentration of each of the overlapped regions 144 is greater than doping concentrations of rest portions in the heavily doped layer 14.

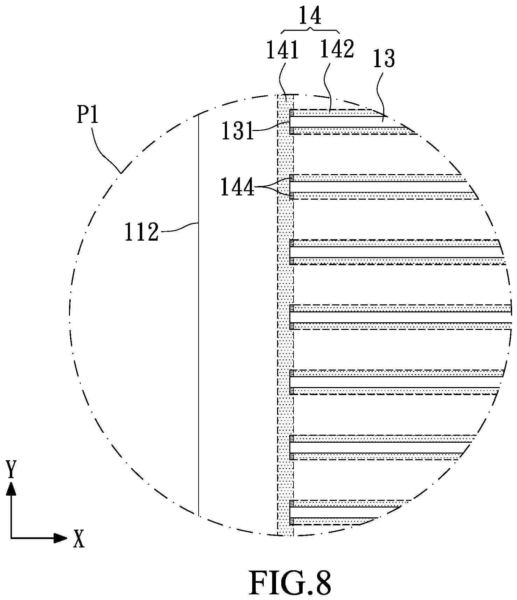

Fig. 8 illustrates a partial enlarged view (7) of the portion P1 shown in Fig. 1. As shown, in this embodiment, the length of each of the second portions 142 along the second direction is greater than the length of each of the finger electrodes 13 along the second direction. In the projecting direction perpendicular to the surface 111 of the solar cell 1, the second portions 142 are partially overlapped with the first portion 141 to form the overlapped regions 144, and the free ends 131 of the finger electrodes 13 are also partially overlapped with the first portion 141. The doping concentration of each of the overlapped regions 144 is greater than doping concentrations of rest portions in the heavily doped layer 14.

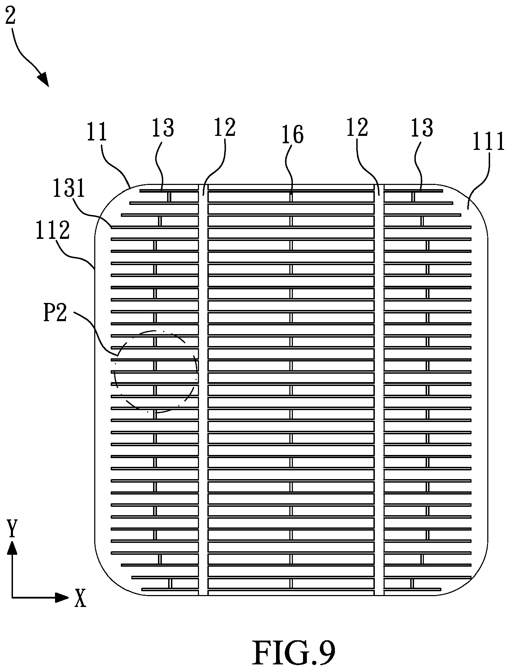

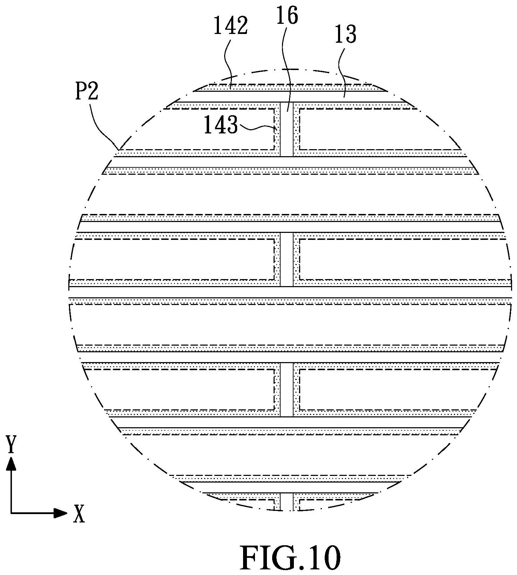

Figs. 9 and 10 respectively illustrate a schematic view of another exemplary embodiment of a solar cell of the instant disclosure showing the electrode layout on the surface thereof and a partial enlarged view of the portion P2 shown in Fig. 9. In this embodiment, the solar cell 2 further comprises a plurality of connection electrodes 16. Two ends of each of the connection electrodes 16 are respectively connected to two of the finger electrodes 13 adjacent to the connection electrode 16. The connection electrodes 16 efficiently reduce the average moving paths of the carriers formed upon the surface 111 being illuminated by sunlight, thereby improving the power generation efficiency of the solar cell 2.

As shown in Fig. 10, the heavily doped layer 14 of the solar cell 2 may further comprise third portions 143. Each of the third portions 143 is extending along the first direction and beneath the corresponding connection electrode 16. Two ends of each of the third portions 143 are respectively connected to two of the second portions 142 adjacent to the third portion 143.

In one embodiment, the doping concentration of the heavily doped layer 14 is from 1 x 10¹⁹ to 8 x 10¹⁹ atom/cm³. In another embodiment, the doping concentration of the heavily doped layer is approximately from 5.43 x 10¹⁸ to 2.84 x 10¹⁹ atom/ cm³. Experiments reveal that the value of 5.43 x 10¹⁸ atom/ cm³ is a critical point for the doping concentration of the heavily doped layer. In other words, when the doping concentration of the heavily doped layer is lower than 5.43 x 10¹⁸ atom/ cm³, the solar cell efficiency does not increase apparently. In addition, the value of 8 x 10¹⁹ atom/ cm³ is a saturation point for the doping concentration of the heavily doped layer 14. In other words, even though the doping concentration of the heavily doped layer 14 is higher than 8 x 10¹⁹ atom/ cm³, the solar cell efficiency cannot get further increase. Moreover, the experiments further reveal the increase of the solar cell efficiency becomes steady when the doping concentration of the heavily doped layer 14 is already higher than 2.84 x 10¹⁹ atom/ cm³.

One feature of one of the embodiment is that the heavily doped region is formed on a region other than the portion beneath the surface electrodes of the solar cell; specifically formed on the region between the free ends 131 of the finger electrodes 13 and the edge 112 of the semiconductor substrate 11 (e.g., the heavily doped region 14 may be formed at the first portion 141 of the embodiment). Accordingly, the resistance between the free ends 131 of the finger electrodes 13 and the edge 112 of the semiconductor substrate 11 is reduced, so that the carriers formed between the free ends 131 of the finger electrodes 13 and the edge 112 of the semiconductor substrate 11 can be collected efficiently, thereby improving the overall power generation efficiency of the solar cell.

While the instant disclosure has been described by the way of example and in terms of the preferred embodiments, it is to be understood that the invention need not be limited to the disclosed embodiments. On the contrary, it is intended to cover various modifications and similar arrangements included within the scope of the appended claims, the scope of which should be accorded the broadest interpretation so as to encompass all such modifications and similar structures.

## Claims

1. A solar cell (1) comprising:
a semiconductor substrate (11) having a surface (111);
a bus-bar electrode (12) on the surface (111) of the semiconductor substrate (11) and extending along a first direction;
a plurality of finger electrodes (13) on the surface of the semiconductor substrate (11) and extending along a second direction, wherein one of two ends of each of the finger electrodes (13) is connected to the bus-bar electrode (12), and an angle defined by the first direction and the second direction is less than 180 degrees; and
a heavily doped layer 14 on the surface (111) of the semiconductor substrate (11) and comprising a first portion (141) and a plurality of second portions (142), wherein the first portion (141) is extending along the first direction, each of the second portions (142) is extending from an edge of the first portion (141) along the second direction, and each of the second portions (142) is beneath the corresponding finger electrode (13), **characterized in that** the first portion (141) of the heavily doped layer (14) is between a free end (131) of each of the finger electrodes (13) and an edge (112) of the semiconductor substrate (11).

2. The solar cell (1) according to claim 1, wherein a length of each of the second portions (142) along the second direction is greater than a length of each of the finger electrodes (13) along the second direction.

3. The solar cell (1) according to claim 1, wherein a length of each of the second portions (142) along the second direction is less than a length of each of the finger electrodes (13) along the second direction.

4. The solar cell (1) according to claim 1, wherein a length of each of the second portions (142) along the second direction is equal to a length of each of the finger electrodes (13) along the second direction.

5. The solar cell (1) according to claim 1, wherein the other end of each of the finger electrodes (13) is a free end.

6. The solar cell (1) according to any claim from claims 1 to 5, wherein a connection between the first portion (141) and each of the second portions (142) are partially overlapped to form an overlapped region (144), a doping concentration of the overlapped region (144) in the heavily doped layer (14) is greater than a doping concentration of rest of the heavily doped layer (14).

7. The solar cell (1) according to claim 6, further comprising a plurality of connection electrodes (16) on the surface (111) of the semiconductor substrate (11), wherein two ends of each of the connection electrodes (16) are respectively connected to two of the finger electrodes (13) adjacent to the connection electrode (16).

8. The solar cell (1) according to claim 7, wherein each of the connection electrodes (16) is extending along the first direction.

9. The solar cell (1) according to claim 8, wherein the heavily doped layer (14) further comprises a plurality of third portions (143), each of the third portions (143) is extending along the first direction and beneath the corresponding connection electrode (16).

10. The solar cell (1) according to claim 9, wherein two ends of each of the third portions (143) are respectively connected to two of the second portions (142) adjacent to the third portion (143).

11. The solar cell (1) according to claim 6, wherein the doping concentration of the heavily doped layer (14) is from 1 x 10¹⁹ to 8 x 10¹⁹ atom/cm³.

12. The solar cell (1) according to claim 6, wherein the doping concentration of the heavily doped layer (14) is from 5.43 x 10¹⁸ to 2.84 x 10¹⁹ atom/ cm³.

## Patentansprüche

1. Eine Solarzelle (1), umfassend:
ein Halbleitersubstrat (11), das eine Fläche (111) aufweist,
eine Sammelleiterelektrode (12) auf der Fläche (111) des Halbleitersubstrats (11), und die sich entlang einer ersten Richtung erstreckt,
eine Mehrzahl von Fingerelektroden (13) auf der Fläche des Halbleitersubstrats (11), und die sich entlang einer zweiten Richtung erstrecken, wobei eines von zwei Enden von jeder der Fingerelektroden (13) mit der Sammelleiterelektrode (12) verbunden ist und ein Winkel, der durch die erste Richtung und die zweite Richtung definiert ist, weniger als 180 Grad beträgt, und
eine stark dotierte Schicht 14 auf der Fläche (111) des Halbleitersubstrats (11) und umfassend einen ersten Abschnitt (141) und eine Mehrzahl von zweiten Abschnitten (142), wobei sich der erste Abschnitt (141) entlang der ersten Richtung erstreckt, jeder der zweiten Abschnitte (142) sich von einem Rand des ersten Abschnitts (141) aus entlang der zweiten Richtung erstreckt und jeder der zweiten Abschnitte (142) unter der korrespondierenden Fingerelektrode (13) liegt, **dadurch gekennzeichnet, dass** der erste Abschnitt (141) der stark dotierten Schicht (14) zwischen einem freien Ende (131) von jeder der Fingerelektroden (13) und einem Rand (112) des Halbleitersubstrats (11) liegt.

2. Die Solarzelle (1) nach Anspruch 1, wobei eine Länge von jedem der zweiten Abschnitte (142) entlang der zweiten Richtung größer als eine Länge von jeder der Fingerelektroden (13) entlang der zweiten Richtung ist.

3. Die Solarzelle (1) nach Anspruch 1, wobei eine Länge von jedem der zweiten Abschnitte (142) entlang der zweiten Richtung kleiner als eine Länge von jeder der Fingerelektroden (13) entlang der zweiten Richtung ist.

4. Die Solarzelle (1) nach Anspruch 1, wobei eine Länge von jedem der zweiten Abschnitte (142) entlang der zweiten Richtung gleich einer Länge von jeder der Fingerelektroden (13) entlang der zweiten Richtung ist.

5. Die Solarzelle (1) nach Anspruch 1, wobei das andere Ende von jeder der Fingerelektroden (13) ein freies Ende ist.

6. Die Solarzelle (1) nach irgendeinem Anspruch der Ansprüche 1 bis 5, wobei eine Verbindung zwischen dem ersten Abschnitt (141) und jedem der zweiten Abschnitte (142) teilweise überlappt ist, um einen Überlappungsbereich (144) auszubilden, wobei eine Dotierkonzentration des Überlappungsbereichs (144) in der stark dotierten Schicht (14) größer als eine Dotierkonzentration des Restes der stark dotierten Schicht (14) ist.

7. Die Solarzelle (1) nach Anspruch 6, ferner umfassend eine Mehrzahl von Verbindungselektroden (16) auf der Fläche (111) des Halbleitersubstrats (11), wobei zwei Enden von jeder der Verbindungselektroden (16) jeweils mit zwei der Fingerelektroden (13) benachbart zu der Verbindungselektrode (16) verbunden sind.

8. Die Solarzelle (1) nach Anspruch 7, wobei sich jede der Verbindungselektroden (16) entlang der ersten Richtung erstreckt.

9. Die Solarzelle (1) nach Anspruch 8, wobei die stark dotierte Schicht (14) ferner eine Mehrzahl von dritten Abschnitten (143) umfasst, wobei sich jeder der dritten Abschnitte (143) entlang der ersten Richtung und unter der korrespondierenden Verbindungselektrode (16) erstreckt.

10. Die Solarzelle (1) nach Anspruch 9, wobei zwei Enden von jedem der dritten Abschnitte (143) jeweils mit zwei der zweiten Abschnitte (142) benachbart zu dem dritten Abschnitt (143) verbunden sind.

11. Die Solarzelle (1) nach Anspruch 6, wobei die Dotierkonzentration der stark dotierten Schicht (14) von 1 x 10¹⁹ bis 8 x 10¹⁹ Atom/cm³ beträgt.

12. Die Solarzelle (1) nach Anspruch 6, wobei die Dotierkonzentration der stark dotierten Schicht (14) von 5,43 x 10¹⁸ bis 2,84 x 10¹⁹ Atom/cm³ beträgt.

## Revendications

1. Pile solaire (1) comprenant :
un substrat à semi-conducteur (11) ayant une surface (111) ;
une électrode de barre de bus (12) sur la surface (111) du substrat à semi-conducteur (11) et qui s'étend le long d'une première direction ;
une pluralité d'électrodes en forme de doigts (13) sur la surface du substrat à semi-conducteur (11) et qui s'étendent le long d'une seconde direction, où l'une des deux extrémités de chacune des électrodes en forme de doigts (13) est reliée à l'électrode de barre de bus (12), et un angle défini par la première direction et la seconde direction est inférieur à 180 degrés ; et
une couche fortement dopée (14) sur la surface (111) du substrat à semi-conducteur (11) et comprenant une première partie (141) et une pluralité de secondes parties (142), où la première partie (141) s'étend le long de la première direction, chacune des secondes parties (142) s'étend depuis un bord de la première partie (141) le long de la seconde direction, et chacune des secondes parties (142) se trouve sous l'électrode en forme de doigt correspondante (13), **caractérisée en ce que**
la première partie (141) de la couche fortement dopée (14) se trouve entre une extrémité libre (131) de chacune des électrodes en forme de doigts (13) et un bord (112) du substrat à semi-conducteur (11).

2. Pile solaire (1) selon la revendication 1, dans laquelle une longueur de chacune des secondes parties (142) le long de la seconde direction est supérieure à une longueur de chacune des électrodes en forme de doigts (13) le long de la seconde direction.

3. Pile solaire (1) selon la revendication 1, dans laquelle une longueur de chacune des secondes parties (142) le long de la seconde direction est inférieure à une longueur de chacune des électrodes en forme de doigts (13) le long de la seconde direction.

4. Pile solaire (1) selon la revendication 1, dans laquelle une longueur de chacune des secondes parties (142) le long de la seconde direction est égale à une longueur de chacune des électrodes en forme de doigts (13) le long de la seconde direction.

5. Pile solaire (1) selon la revendication 1, dans laquelle l'autre extrémité de chacune des électrodes en forme de doigts (13) est une extrémité libre.

6. Pile solaire (1) selon l'une quelconque des revendications 1 à 5, dans laquelle une liaison entre la première partie (141) et chacune des secondes parties (142) est partiellement chevauchée afin de former une zone chevauchée (144), et une concentration de dopage de la zone chevauchée (144) dans la couche fortement dopée (14) est supérieure à une concentration de dopage du reste de la couche fortement dopée (14).

7. Pile solaire (1) selon la revendication 6, comprenant en outre une pluralité d'électrodes de liaison (16) sur la surface (111) du substrat à semi-conducteur (11), dans laquelle les deux extrémités de chacune des électrodes de liaison (16) sont respectivement reliées à deux des électrodes en forme de doigts (13) adjacentes à l'électrode de liaison (16).

8. Pile solaire (1) selon la revendication 7, dans laquelle chacune des électrodes de liaison (16) s'étend le long de la première direction.

9. Pile solaire (1) selon la revendication 8, dans laquelle la couche fortement dopée (14) comprend en outre une pluralité de troisièmes parties (143), chacune des troisièmes parties (143) s'étendant le long de la première direction et sous l'électrode de liaison correspondante (16).

10. Pile solaire (1) selon la revendication 9, dans laquelle deux extrémités de chacune des troisièmes parties (143) sont respectivement reliées à deux des secondes parties (142) adjacentes à la troisième partie (143).

11. Pile solaire (1) selon la revendication 6, dans laquelle la concentration de dopage de la couche fortement dopée (14) est comprise entre 1 x 10¹⁹ et 8 x 10¹⁹ atomes/cm³.

12. Pile solaire (1) selon la revendication 6, dans laquelle la concentration de dopage de la couche fortement dopée (14) est comprise entre 5,43 x 10¹⁸ et 2,84 x 10¹⁹ atomes/cm³.
